# EUROPEAN PATENT APPLICATION

(11) **EP 4 349 590 A1**
(43) Date of publication of application: **10.04.2024**
(21) Application number: 22810900.5
(22) Date of filing: 03.03.2022
(51) Int. Cl.: B32B 27/00, B32B 27/18, C08L 21/00, C08L 23/00, C08L 81/02, C08L 101/00, B32B 15/08, B32B 37/14, C08K 3/013, C08K 3/26, C23C 18/22, H05K 9/00, B32B 7/025, C08J 7/12

(54) **ELECTROMAGNETIC WAVE-SHIELDING MEMBER AND METHOD FOR MANUFACTURING SAME**

(30) Priority: 25.05.2021 JP 2021087490
(71) Applicant: DIC Corporation, Tokyo 174-8520 (JP)
(72) Inventor: AOKI, Takamichi, Ichihara-shi, Chiba 290-8585 (JP); KANDA, Tomomichi, Ichihara-shi, Chiba 290-8585 (JP)
(74) Representative: Kraus & Lederer PartGmbB
(86) International application number: PCT/JP2022/009017
(87) International publication number: WO 2022/249619

(57) **Abstract**

Provided is a method for manufacturing an electromagnetic wave-shielding member that is a laminated body having a plating layer that can be formed on a surface of a polyarylene sulfide (PAS) molded product by a simple step through high adhesive strength and has excellent electric field shielding properties and magnetic field shielding properties. More particularly, provided are an electromagnetic wave-shielding member and a method for manufacturing the electromagnetic wave-shielding member that is a laminated body including a step of roughening a surface of a molded product obtained by molding a PAS resin composition by a chemical etching treatment, and a step of subjecting the roughened surface of the molded product to a plating treatment, wherein the laminated body has a plating layer on at least two surfaces that are paired, and the PAS resin composition is obtained by mixing a PAS resin (A), a thermoplastic resin (B) other than the polyarylene sulfide resin selected from the group consisting of a thermoplastic elastomer (b1) and a hydrolyzable thermoplastic resin (b2), a carbonate (C), and a polyolefin wax (D).

## Description

### Technical Field

The present invention relates to an electromagnetic wave-shielding member and a method for manufacturing the same. More particularly, the present invention relates to an electromagnetic wave-shielding member that is a laminated body having a plating layer that can be simply formed on a surface of a molded product (hereinafter referred to as a polyarylene sulfide resin molded product) formed by molding a polyarylene sulfide resin composition through high adherence and a method for manufacturing the same.

### Background Art

In recent years, in order to decrease fuel cost due to the weight saving of a vehicle in the automotive field, many attempts to replace various metal members by engineering plastics that are lighter and have heat resistance and chemical resistance have proceeded. In particular, a polyarylene sulfide (hereinafter sometimes abbreviated as PAS) resin typified by a polyphenylene sulfide (hereinafter sometimes abbreviated as PPS) resin has high heat resistance and excellent mechanical strength, chemical resistance, molding processability, and dimensional stability. Therefore, the PAS resin has been widely used.

On the other hand, many electronic control systems are mounted on a vehicle with an increase in an electric component in the vehicle, and this causes a concern about an influence on the human body of an electromagnetic wave generated from a high-voltage part. For example, an inverter that is a fundamental component of an electric motor is known to generate a low-frequency electromagnetic wave having a frequency of about 100 kHz. Based on such a background, an ability of shielding a low-frequency electromagnetic wave is required for various resin casings of automotive parts, in addition to shielding of highfrequency electromagnetic wave that has been conventionally required.

Since an electromagnetic wave-shielding performance of a PAS resin that is an organic substance is low, a procedure of forming a thin film layer containing a metal or ceramic on a surface of a resin molded product is generally adopted. However, since the adhesion (adherence) of a PAS resin composition or a PAS resin molded product to another material is low due to high chemical resistance of the PAS resin, there is a problem in that a metal film formed on the surface of the PAS resin composition or PAS resin molded product is likely to be peeled.

As a method for solving the problem, a method in which the surface of the PAS resin molded product is etched with an etchant, a palladium catalyst is added, and electroless copper plating is carried out to form a copper plating layer is proposed (for example, see PTL 1). However, this method also causes a problem in that the surface of the PAS resin molded product becomes fragile due to erosion by the etchant, to easily peel the copper plating layer formed on the surface of the PAS resin molded product with time.

Furthermore, a method in which the surface of the PAS resin molded product is roughened by sand blasting, shot blasting, or the like, and then coated with a primer resin to enhance an adhesive strength to a coating film by metal vapor deposition, metal plating, or the like, is proposed (see PTL 2). However, a surface of a polyphenylene sulfide is roughened to a depth of 1 to 10 um to achieve sufficient adhesive strength. Therefore, this method is not suitable for a member requiring surface smoothness.

In addition, a method for forming a metal film on a surface of a polyphenylene sulfide by a method in which on the surface of the PAS resin molded product, a primer resin layer and a metal layer containing metal particles are each formed by an immersion method, and a metal plating layer is formed by an electrolytic plating method, an electroless plating method, or the like, is proposed (see PTLs 3 and 4). However, this method is a method for forming the primer resin layer, the metal layer containing metal particles, and the metal plating layer successively on the surface of the PAS resin molded product, and thus has a large number of steps. Therefore, from the viewpoint of productivity, proposition of a method in which the number of steps is small is desired.

### Citation List

### Patent Literature

PTL 1: Japanese Unexamined Patent Application Publication No. 63-14880
PTL 2: Japanese Unexamined Patent Application Publication No. 2002-97292
PTL 3: International Publication WO2017/154879
PTL 4: Japanese Patent No. 6355008

### Summary of Invention

### Technical Problem

An object of the present invention is to provide an electromagnetic wave-shielding member that is a laminated body having a plating layer that can be formed on a surface of a PAS resin molded product by a simple step through high adhesive strength and has excellent electric field shielding properties and magnetic field shielding properties, and a method for manufacturing the same.

### Solution to Problem

The inventors of the present invention have intensively studied to solve the aforementioned problems, and as a result, found that when a molded product obtained by melt-molding a PAS resin composition obtained by mixing a PAS resin (A), a thermoplastic resin (B) other than the PAS resin selected from the group consisting of a thermoplastic elastomer (b1) and a hydrolyzable thermoplastic resin (b2), a carbonate (C), and a polyolefin wax (D) is roughened by a chemical etching treatment, a plating film formed on the roughened surface by a plating treatment exhibits high adhesive strength, and when at least two surfaces that are paired are further subjected to a plating treatment, the molded product is more excellent in electric field shielding properties and magnetic field shielding properties. Thus, the present invention has been completed.

Specifically, the present disclosure relates to a method for manufacturing an electromagnetic wave-shielding member that is a laminated body including:
a step of roughening a surface of a molded product obtained by molding a PAS resin composition by a chemical etching treatment, and
a step of subjecting the roughened surface of the molded product to a plating treatment, wherein
the laminated body has a plating layer on at least two surfaces that are paired, and
the PAS resin composition is obtained by mixing a PAS resin (A), a thermoplastic resin (B) other than the PAS resin selected from the group consisting of a thermoplastic elastomer (b1) and a hydrolyzable thermoplastic resin (b2), a carbonate (C), and a polyolefin wax (D).

The present disclosure relates to an electromagnetic wave-shielding member that is a laminated body obtained by laminating a plating layer on a roughened surface of a molded product obtained by molding a PAS resin composition, wherein
the plating layer of the laminated body is provided on at least two surfaces that are paired, and
the PAS resin composition is obtained by mixing a PAS resin (A), a thermoplastic resin (B) other than the PAS resin selected from the group consisting of a thermoplastic elastomer (b1) and a hydrolyzable thermoplastic resin (b2), a carbonate (C), and a polyolefin wax (D).

In the present disclosure, binding the surface of the PAS resin molded product to the plating layer is expressed as adhesion or close contact.

### Advantageous Effects of Invention

The present invention can provide an electromagnetic wave-shielding member that is a laminated body having a plating layer that can be formed on a surface of a PAS resin molded product by a simple step through high adhesive strength, and a method for manufacturing the same. Description of Embodiments

A method for manufacturing an electromagnetic wave-shielding member of the present disclosure is a method for manufacturing an electromagnetic wave-shielding member that is a laminated body including
a step of roughening a surface of a molded product obtained by molding a PAS resin composition as a support by a chemical etching treatment, and
a step of subjecting the roughened surface of the support to a plating treatment, wherein
the laminated body has a plating on at least two surfaces that are paired, and
the PAS resin composition is obtained by mixing a PAS resin (A), a thermoplastic resin (B) other than the PAS resin selected from the group consisting of a thermoplastic elastomer (b1) and a hydrolyzable thermoplastic resin (b2), a carbonate (C), and a polyolefin wax (D).

### <PAS Resin (A)>

The PAS resin (A) has a resin structure including as a repeating unit a structure in which an aromatic ring is bonded to a sulfur atom. Specifically, the PAS resin (A) is a resin including as a repeating unit a structural moiety represented by the following general formula (1). 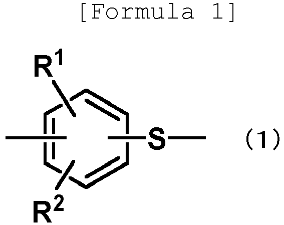 (wherein R¹ and R² are each independently a hydrogen atom, an alkyl group having 1 to 4 carbon atoms, a nitro group, an amino group, a phenyl group, a methoxy group, or an ethoxy group.)

R¹ and R² in the general formula (1) are preferably a hydrogen atom in terms of mechanical strength of the PAS resin (A). In this case, examples of the structural moiety include a structural moiety represented by the following general formula (2) and having bonds at para positions and a structural moiety represented by the following general formula (3) and having bonds at meta positions.

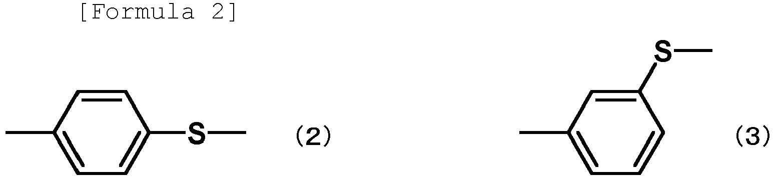

In particular, the structural moiety represented by the general formula (2) in which a bond of the aromatic ring to the sulfur atom in the repeating unit is a bond at a para position is preferred since the heat resistance and crystallinity of the PAS resin (A) are improved.

The PAS resin (A) may have not only the structural moiety represented by the general formula (1) but also at least one selected from structural moieties represented by the following general formulae (4) to (7). When the PAS resin (A) has the structural moieties represented by the general formulae (4) to (7), the molar ratio of the structural moieties in the PAS resin (A) is preferably 30 mol% or less, and more preferably 10 mol% or less from the viewpoint of achieving favorable heat resistance and mechanical strength.

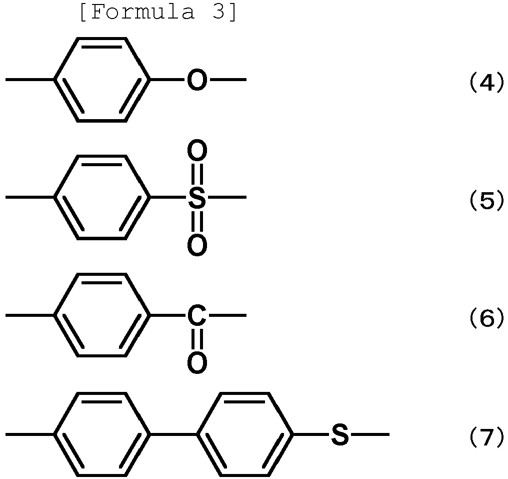

When the PAS resin (A) has the structural moieties represented by the general formulae (4) to (7), a bond of the structural moiety represented by the general formula (1) to the repeating unit may be in a random mode or a block mode.

Further, the PAS resin (A) may have a trifunctional structural moiety represented by the following general formula (8), a naphthyl sulfide bond, or the like. In this case, the molar ratio of the structural moiety in the PAS resin (A) is preferably 3 mol% or less, and more preferably 1 mol% or less.

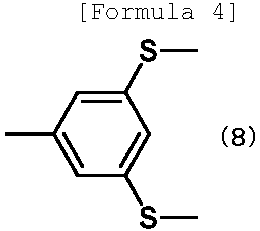

The PAS resin (A) can be produced, for example, by the following methods (1) to (4).
(1) A method in which sodium sulfide is reacted with p-dichlorobenzene in an amide solvent such as N-methylpyrrolidone or dimethylacetamide or a sulfone solvent such as sulfolane.
(2) A method in which p-dichlorobenzene is polymerized in the presence of sulfur and sodium carbonate.
(3) A method in which polymerization is carried out by adding sodium sulfide, a mixture of sodium hydrosulfide and sodium hydroxide, or a mixture of sodium sulfide and sodium hydroxide dropwise to a mixed solvent of a polar solvent and p-dichlorobenzene.
(4) A method in which p-chlorothiophenol is self-condensed.

Among these methods, the method (1) in which sodium sulfide is reacted with p-dichlorobenzene in an amide solvent such as N-methylpyrrolidone or dimethylacetamide or a sulfone solvent such as sulfolane is preferred since reaction control is easy and excellent industrial productivity is achieved. In this method (1), addition of an alkali such as an alkali metal salt of carboxylic acid, an alkali metal salt of sulfonic acid, or a hydroxide to adjust a polymerization degree is preferred.

The melt viscosity measured at 300°C of the PAS resin is preferably 2 Pa·s or more, more preferably 10 Pa·s or more, and further preferably 60 Pa·s or more, and preferably 1,000 Pa·s or less, more preferably 500 Pa·s or less, and further preferably 200 Pa·s or less. A melt viscosity of 2 Pa·s or more is preferred since material strength can be kept. On the other hand, a melt viscosity of 1,000 Pa·s or less is preferred from the viewpoint of moldability. In the present description, as a value of "melt viscosity", a value obtained by measuring a melt viscosity (V6) at 300°C, a load of 1.96×10⁶ Pa, and L/D = 10 (mm)/1 (mm) with a Koka flow tester (CFT-500D manufactured by Shimadzu Corporation) after holding the PAS resin for 6 minutes is adopted.

It is preferable that the PAS resin (A) be produced, treated with an acid, and then cleaned with water since the PAS resin (A) can decrease the amount of remaining metal ion to improve humidity resistance, and can decrease the amount of remaining low-molecular-weight impurity that is secondarily produced during polymerization.

For example, the acid used in the acid treatment is preferably acetic acid, hydrochloric acid, sulfuric acid, phosphoric acid, silicic acid, carbonic acid, or propyl acid. Among the acids, acetic acid and hydrochloric acid are preferred since the amount of remaining metal ion can be efficiently decreased without decomposing the PAS resin (A).

Examples of a method for the acid treatment include a method in which the PAS resin (A) is immersed in an acid or an acidic aqueous solution. In this case, stirring or heating may be further carried out, if necessary.

Specific examples of the method for the acid treatment include a method using acetic acid in which an acetic acid aqueous solution with a pH of 4 is heated to 80 to 90°C and the PAS resin (A) is then immersed in the acetic acid aqueous solution and stirred for 20 to 40 minutes.

The PAS resin (A) thus treated with the acid is cleaned with water or hot water several times to physically remove the remaining acid and salt. The water used at that time is preferably distilled water or de-ionized water.

The PAS resin (A) subjected to the acid treatment is preferably in a powder form. Specifically, the PAS resin (A) may be in a powder form, like pellets, or in a slurry form after polymerization.

### <Thermoplastic Resin (B) other than PAS Resin>

The PAS resin composition of the present invention contains as an essential component the thermoplastic resin (B) other than the PAS resin selected from the group consisting of the thermoplastic elastomer (b1) and the hydrolyzable thermoplastic resin (b2) since the adhesive strength of the plating layer formed by the plating treatment to the PAS resin molded product in the present disclosure is enhanced.

The thermoplastic elastomer (b1) used in the present disclosure is not particularly limited as long as it is a known one. The thermoplastic elastomer (b1) is preferably removed by a chemical etching treatment described below. Specific examples thereof include a polyolefin thermoplastic elastomer (sometimes referred to as "olefin copolymer-based thermoplastic elastomer"), a fluorocarbon thermoplastic elastomer, a silicone thermoplastic elastomer, a styrenic thermoplastic elastomer, a fluoropolymer thermoplastic elastomer, and a urethane resin-based thermoplastic elastomer. In particular, a polyolefin thermoplastic elastomer is preferred.

Examples of the polyolefin thermoplastic elastomer include a homopolymer of α-olefin, a copolymer of two or more α-olefins, and a copolymer of one or two or more α-olefins with a vinyl polymerizable compound having a functional group. Examples of the α-olefins include α-olefins having 2 or more and 8 or less carbon atoms, such as ethylene, propylene, and 1-butene. Examples of the functional group include a carboxy group, an acid anhydride group (-C(=O)OC(=O)-), an epoxy group, an amino group, a hydroxyl group, a mercapto group, an isocyanate group, and an oxazoline group. Examples of the vinyl polymerizable compound having the functional group include one or two or more of vinyl acetate; an α,β-unsaturated carboxylic acid, such as (meth)acrylic acid; an alkyl ester of an α,β-unsaturated carboxylic acid, such as methyl acrylate, ethyl acrylate, and butyl acrylate; a metal salt of an α,β-unsaturated carboxylic acid, such as an ionomer (in which the metal is an alkali metal such as sodium, an alkaline earth metal such as calcium, zinc, or the like); a glycidyl ester of an α,β-unsaturated carboxylic acid, such as glycidyl methacrylate; an α,β-unsaturated dicarboxylic acid, such as maleic acid, fumaric acid, and itaconic acid; and a derivative (monoester, diester, acid anhydride) of the α,β-unsaturated dicarboxylic acid. Additional examples thereof include an ethylene-propylene rubber (EPM), an ethylene-propylene-diene rubber (EPDM), a butadiene rubber, a chloroprene rubber, a nitrile rubber, a butyl rubber, and an acrylic rubber. Examples of the styrenic thermoplastic elastomer include a styrene-butadiene rubber (SBR) and a hydrogenated SBR. Examples thereof include a silicone thermoplastic elastomer such as a silicone rubber, a fluoropolymer thermoplastic elastomer such as a fluorocarbon rubber, and a urethane resin-based thermoplastic elastomer such as a urethane rubber. The thermoplastic elastomer may be used alone, or two or more types thereof may be used in combination.

The hydrolyzable thermoplastic resin (b2) is not particularly limited as long as it is a known hydrolyzable thermoplastic resin, and is preferably a resin that exhibits hydrolyzability by a chemical etching treatment described below. Specific examples thereof include a polyamide resin, a polyester resin, a polycarbonate resin, a polyether resin, a polyurethane resin, a polyketone resin, a polylactone resin, a polyacetal resin, a polyimide resin, a polyamideimide resin, a polyarylate resin, a polyetherimide resin, a polyetherether ketone resin, a thermoplastic epoxy resin, a thermoplastic phenolic resin, and a copolymer having the resin structure described above.

Among the thermoplastic resins (b2), a polyamide resin and a polycarbonate resin are preferred, and a polyamide resin is more preferred, from the viewpoint of excellent adhesive strength of the plating layer to the obtained PAS resin molded product.

Examples of the aromatic polyamide resin include an aromatic polyamide resin having a repeating unit represented by the following structural formula (10).

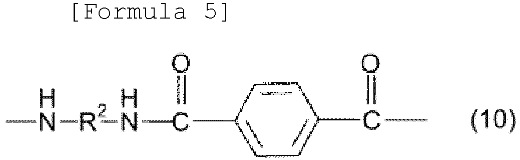

In the structural formula (10), R² represents an alkylene group having 2 or more and 12 or less carbon atoms. Such a terephthalic acid amide structure is specifically formed by a reaction of terephthalic acid or terephthalic acid dihalide with an aliphatic diamine having 2 or more and 12 or less carbon atoms. Specific examples of the aliphatic diamine having 2 or more and 12 or less carbon atoms used herein include linear aliphatic alkylenediamines such as ethylenediamine, propanediamine, 1,4-butanediamine, 1,6-hexanediamine, 1,7-heptanediamine, 1,8-octanediamine, 1,9-nonanediamine, 1,10-decanediamine, 1,11-undecanediamine, and 1,12-dodecanediamine; branched aliphatic alkylenediamines such as 1-butyl-1,2-ethanediamine, 1,1-dimethyl-1,4-butanediamine, 1-ethyl-1,4-butanediamine, 1,2-dimethyl-1,4-butanediamine, 1,3-dimethyl-1,4-butanediamine, 1,4-dimethyl-1,4-butanediamine, 2,3-dimethyl-1,4-butanediamine, 2-methyl-1,5-pentanediamine, 3-methyl-1,5-pentanediamine, 2,5-dimethyl-1,6-hexanediamine, 2,4-dimethyl-1,6-hexanediamine, 3,3-dimethyl-1,6-hexanediamine, 2,2-dimethyl-1,6-hexanediamine, 2,2,4-trimethyl-1,6-hexanediamine, 2,4,4-trimethyl-1,6-hexanediamine, 2,4-diethyl-1,6-hexanediamine, 2,2-dimethyl-1,7-heptanediamine, 2,3-dimethyl-1,7-heptanediamine, 2,4-dimethyl-1,7-heptanediamine, 2,5-dimethyl-1,7-heptanediamine, 2-methyl-1,8-octanediamine, 3-methyl-1,8-octanediamine, 4-methyl-1,8-octanediamine, 1,3-dimethyl-1,8-octanediamine, 1,4-dimethyl-1,8-octanediamine, 2,4-dimethyl-1,8-octanediamine, 3,4-dimethyl-1,8-octanediamine, 4,5-dimethyl-1,8-octanediamine, 2,2-dimethyl-1,8-octanediamine, 3,3-dimethyl-1,8-octanediamine, 4,4-dimethyl-1,8-octanediamine, and 5-methyl-1,9-nonanediamine; and alicyclic diamines such as cyclohexanediamine, methylcyclohexanediamine, isophoronediamine, norbornanedimethylamine, and tricyclodecanedimethylamine.

Among these, from the viewpoint of more excellent adhesive strength of the plating layer to the obtained PAS resin molded product, a linear aliphatic alkylenediamine having 4 or more and 8 or less carbon atoms and a branched aliphatic alkylenediamine having 5 or more and 10 or less carbon atoms are particularly preferred.

Examples of the aromatic polyamide resin include an aromatic polyamide resin having a repeating unit represented by the following structural formula (11). 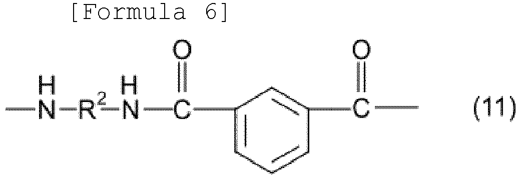 (In the formula, R² is synonymous with R² in the structural formula (10).)

The aromatic polyamide resin may further have an acid amide structure represented by the following structural formula (12). 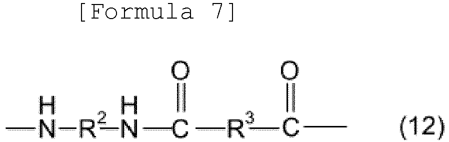 (In the formula, R² is synonymous with R² in the structural formula (10), and R³ represents an aliphatic hydrocarbon group having 4 or more and 10 or less carbon atoms.)

Herein, the acid amide structure represented by the structural formula (12) is formed by a reaction of an aliphatic dicarboxylic acid having 4 or more and 10 or less carbon atoms, an acid-esterified product, acid anhydride, or acid halide thereof with an aliphatic diamine having 2 or more and 12 or less carbon atoms. Specific examples of the aliphatic dicarboxylic acid having 4 or more and 10 or less carbon atoms used herein include aliphatic dicarboxylic acids such as malonic acid, dimethylmalonic acid, succinic acid, glutaric acid, adipic acid, 2-methyladipic acid, trimethyladipic acid, pimelic acid, 2,2-dimethylglutaric acid, 3,3-diethylsuccinic acid, azelaic acid, sebacic acid, and suberic acid; and aliphatic dicarboxylic acids including alicyclic dicarboxylic acids such as 1,3-cyclopentanedicarboxylic acid and 1,4-cyclohexanedicarboxylic acid.

Specific examples of the acid-esterified product of the aliphatic dicarboxylic acid having 4 or more and 10 or less carbon atoms include a methyl ester product, an ethyl ester product, and a t-butyl ester product. Examples of a halogen atom constituting the acid halide of the aliphatic dicarboxylic acid include a bromine atom and a chlorine atom.

The aromatic polyamide resin preferably has as a structural moiety the amide structure represented by the structural formula (10), the structural formula (11), or the structural formula (12) as described above. When one unit is an acid amide structure consisting of a dicarboxylic acid molecule and a diamine molecule, it is preferable that 50 mol% or more of the terephthalic acid amide structure, 10 mol% or more of an isophthalic acid amide structure, and 5 mol% or more of an aliphatic hydrocarbon acid amide structure be contained with respect to all the acid amide structures constituting the aromatic polyamide resin from the viewpoint of more excellent adhesive strength of the plating layer to the obtained PAS resin molded product.

From the viewpoint of more excellent adhesive strength of the plating layer to the obtained PAS resin molded product, the aromatic polyamide resin is preferably a polyamide resin having 50 mol% or more and 80 mol% or less of the terephthalic acid amide structure represented by the structural formula (10), 10 mol% or more and 30 mol% or less of the isophthalic acid amide structure represented by the structural formula (11), and 5 mol% or more and 20 mol% or less of the acid amide structure represented by the structural formula (12).

From the viewpoint of decreasing the recrystallization peak temperature of the aromatic polyamide resin and achieving favorable dispersibility with the PAS resin, the melting point is preferably within the range of 290°C or higher and 330°C or lower, and the glass transition temperature is preferably within the range of 90°C or higher and 140°C or lower.

The aromatic polyamide resin can be produced by the following methods (1) to (3).
(1) An interfacial polymerization method in which an acid halide of a dicarboxylic acid component including terephthalic acid and a diamine component including an aliphatic diamine having 2 or more and 12 or less carbon atoms are dissolved in each of two types of solvents that are not compatible with each other, and two solutions are mixed and stirred in the presence of an alkali and a catalytic amount of quaternary ammonium salt, resulting in a polycondensation reaction.
(2) A solution polymerization method in which an acid halide of a dicarboxylic acid component including terephthalic acid and a diamine component including an aliphatic diamine having 2 or more and 12 or less carbon atoms are reacted in the presence of an alkaline compound receiving an acid, such as tertiary amine, in an organic solvent.
(3) A melt polymerization method in which a diesterified product of a dicarboxylic acid component including terephthalic acid and an aromatic diamine in a molten state as raw materials are subjected to an amide exchange reaction.

The amount of the thermoplastic resin (B) mixed is not particularly limited. From the viewpoint of further enhancing the adhesive strength of the plating layer formed by the plating treatment, the total amount of the thermoplastic resin (B) other than the PAS resin selected from the group consisting of the thermoplastic elastomer (b1) and the hydrolyzable thermoplastic resin (b2) is preferably 5 parts by mass or more, more preferably 15 parts by mass or more, and further preferably 30 parts by mass or more, and preferably 70 parts by mass or less, more preferably 60 parts by mass or less, and further preferably 50 parts by mass or less, relative to 100 parts by mass of the PAS resin (A).

### <Carbonate (C)>

The PAS resin composition of the present invention further contains as an essential component the carbonate (C) since the adhesive strength of the plating layer formed by the plating treatment to the PAS resin molded product in the present disclosure is enhanced. The carbonate (C) is not particularly limited as long as it is a known one. Preferable examples thereof include a carbonate (C) to be removed by a chemical etching treatment described below. Specific examples thereof include calcium carbonate, magnesium carbonate, potassium carbonate, sodium carbonate, sodium bicarbonate, ammonium carbonate, barium carbonate, lithium carbonate, copper (II) carbonate, iron (II) carbonate, silver (I) carbonate, manganese carbonate, zinc carbonate, dolomite, and hydromagnesite. In particular, calcium carbonate is preferred.

The size of the carbonate (C) is not particularly limited. From the viewpoint of excellent adhesive strength of the plating layer to the obtained PAS resin molded product, the average particle diameter of the carbonate (C) is preferably 6 um or less, more preferably 3 um or less, and further preferably 1.2 um or less. The lower limit value thereof is not limited, and is preferably 0.3 um or more, more preferably 0.5 um or more, and still more preferably 0.8 um or more. The average particle diameter can be obtained from an observation photograph of a cross section of the obtained molded product by an electron microscope. For example, a method in which the particle diameters of at least any 100 particles within an observation range that is 3,000 times of one side are measured and the average value thereof is determined is exemplified.

The amount of the carbonate (C) mixed is not particularly limited. From the viewpoint of further enhancing the adhesive strength of the plating layer formed by the plating treatment, the amount is preferably 10 parts by mass or more, more preferably 25 parts by mass or more, and further preferably 40 parts by mass or more, and preferably 90 parts by mass or less, more preferably 80 parts by mass or less, and further preferably 70 parts by mass or less, relative to 100 parts by mass of the PAS resin (A) .

### <Polyolefin Wax (D)>

The PAS resin composition of the present invention further contains as an essential component the polyolefin wax (D) since the adhesive strength of the plating layer formed by the plating treatment to the PAS resin molded product in the present disclosure is enhanced.

The polyolefin wax used in the present disclosure includes a known wax having a polyolefin structure obtained by polymerization of a monomer having an olefin structure. In the present invention, the wax refers to a wax that is produced by polymerization, is normally a low-molecular-weight resin in a solid state at 25°C, and exhibits a mold release effect in a mold, for example, during melt-molding when the wax is an additive to the PAS resin composition. The wax generally represents a wax having a molecular weight (Mn) of preferably 250 or more, and more preferably 300 or more, and preferably 20,000 or less, and more preferably 10,000 or less. The wax having a molecular weight of 250 or more can suppress volatilization from a vacuum vent during melt-kneading or during melt-molding, and tends to exert a mold release effect. In addition, the wax may reduce a cause of mold contamination due to excessive bleeding-out of the wax during molding. On the other hand, the wax having a molecular weight of 20,000 or less tends to bleed out, and improve the mold release effect.

As the polyolefin wax (D), a polyethylene wax and/or 1-alkene polymer obtained by polymerization of ethylene and/or 1-alkene as a raw material is particularly preferably used. In this case, not only an extremely favorable mold release effect is obtained, but also more excellent adhesive strength of the plating layer to the obtained PAS resin molded product is achieved. As a method for producing a polyethylene wax, a generally and widely known method can be used. Examples thereof include polymerization of ethylene at a high temperature and a high pressure, thermal decomposition of polyethylene, and separation and purification of a low-molecular-weight component from a polyethylene polymer. Examples of the 1-alkene include propylene, 1-butene, 1-pentene, 1-hexene, 1-heptene, 1-octene, 1-nonene, 1-decene, 1-dodecene, 1-tetradecene, 1-hexadecene, 1-heptadecene, 1-octadecene, 1-nonadecene, 1-eicosene, 1-heneicosene, 1-docosene, 1-tricosene, 1-tetracosene, 1-pentacosene, 1-hexacosene, 1-heptacosene, 1-octacosene, and 1-nonacosene. As an aliphatic hydrocarbon group constituting the polyolefin wax (D) used in the present invention, both a linear aliphatic hydrocarbon group and a branched aliphatic hydrocarbon group can be used.

The polyolefin wax (D) used in the present disclosure may have a polar group. Examples of the polar group include at least one selected from the group consisting of a carboxy group, an acid anhydride, an amino group, a hydroxy group, a thiol group, an epoxy group, an ether bond, an ester bond, an amide bond, an imide bond, a urea bond, a urea bond, and a sulfide bond. When the polyolefin wax (D) used in the present invention has a polar group, examples of the polyolefin wax (D) include a compound having at least one selected from the group consisting of a carboxy group, an acid anhydride, an amino group, a hydroxy group, a thiol group, an epoxy group, an ether bond, an ester bond, an amide bond, an imide bond, a urea bond, a urea bond, and a sulfide bond that can be copolymerized with such a monomer during polymerization or copolymerization of the ethylene and/or 1-alkene, and an ethylenically double bond, and preferably a compound obtained by copolymerization of maleic anhydride or maleic anhydride and maleic acid.

The amount of the polyolefin wax (D) mixed is not particularly limited. From the viewpoint of further enhancing the adhesive strength of the plating layer formed by the plating treatment, the amount is preferably 0.01 parts by mass or more, more preferably 0.05 parts by mass or more, and further preferably 0.1 parts by mass or more, and preferably 10 parts by mass or less, more preferably 5 parts by mass or less, and further preferably 2 parts by mass or less, relative to 100 parts by mass of the PAS resin (A).

### <Other Optional Component>

The PAS resin composition of the present disclosure can further contain a filler other than the carbonate (C) as an optional component. As the filler, a commonly known material can be used as long as it impairs the effects of the present invention. Examples thereof include a granular filler, a fibrous filler, and fillers having various shapes. Specifically, a fibrous filler including natural fibers such as glass fibers, carbon fibers, silane glass fibers, ceramic fibers, aramid fibers, metal fibers, fibers of potassium titanate, silicon carbide, calcium sulfate, or calcium silicate, or wollastonite can be used. Barium sulfate, calcium sulfate, clay, pyrophyllite, bentonite, sericite, zeolite, mica (mica), talc, attapulgite, ferrite, calcium silicate, glass beads, or the like, can be used. Although the filler used in the present invention is not an essential component, the amount of the filler mixed during use is not particularly limited as long as it does not impair the effects of the present invention. The amount varies according to the purpose thereof, and cannot be unconditionally defined. For example, the filler is mixed in an amount of preferably 10 parts by mass or more, and more preferably 40 parts by mass or more, and preferably 90 parts by mass or less, and more preferably 70 parts by mass or less, relative to 100 parts by mass of the PAS resin. The filler in an amount falling within the range can improve various performances such as strength, rigidity, heat resistance, heat dissipation properties, and dimensional stability, according to the purpose of the filler added.

The filler that is processed with a surface treatment agent or a sizing agent can be used. This is preferred since the adhesive strength to the PAS resin (A) can be enhanced. Examples of the surface treatment agent or the sizing agent include at least one type of polymer selected from the group consisting of a silane compound, a titanate compound, an acrylic resin, a urethane resin, and an epoxy resin having a functional group, such as an amino group, an epoxy group, an isocyanate group, or a vinyl group.

As the component other than the thermoplastic resin (B) and the polyolefin wax (D), the PAS resin composition of the present disclosure can appropriately contain as the optional component a synthetic resin, for example, an epoxy resin, a polyimide resin, a polyetherimide resin, a polyphenylene ether resin, a polysulfone resin, a polyethersulfone resin, a polyetherether ketone resin, a polyether ketone resin, a polyarylene resin, a polyethylene resin, a polypropylene resin, a poly(ethylene tetrafluoride) resin, a poly(ethylene difluoride) resin, a polystyrene resin, an ABS resin, a phenol resin, and a urethane resin, or a synthetic resin such as a liquid crystal polymer (hereinafter sometimes simply referred to as synthetic resin) according to use applications. In the present invention, the synthetic resin is not an essential component. When the synthetic resin is mixed, the amount of the synthetic resin mixed is not particularly limited as long as it does not impair the effects of the present invention. The amount varies according to the purpose thereof, and can be generally defined. For example, the amount of the synthetic resin mixed in the resin composition according to the present invention is within the range of 5 parts by mass or more and 15 parts by mass or less relative to 100 parts by mass of the PAS resin (A). In other words, the ratio by mass of the PAS resin (A) to the total amount of the PAS resin (A) and the synthetic resin is preferably 100/115 or more, and more preferably 100/105 or more.

Furthermore, the PAS resin composition of the present disclosure may contain as an optional component a commonly known additive such as a colorant, an antistat, an antioxidant, a heat-resistant stabilizer, an ultraviolet stabilizer, an ultraviolet absorber, a foaming agent, a flame retarder, a flame retardant promoter, an antirust agent, or a coupling agent, if necessary. The additive is not an essential component. When the additive is mixed, the amount of the additive mixed is not particularly limited as long as it does not impair the effects of the present invention. The amount varies according to the purpose thereof, and can be generally defined. The amount is preferably within the range of 0.01 parts by mass or more and 1,000 parts by mass or less relative to 100 parts by mass of the PAS resin (A). The amount may be appropriately adjusted according to the purpose and use application for use without impairing the effects of the present invention.

### <Method for Manufacturing Electromagnetic Wave-Shielding Member>

An electromagnetic wave-shielding member of the present disclosure is an electromagnetic wave-shielding member that is a laminated body obtained by laminating a plating layer on a roughened surface of a molded product obtained by molding the PAS resin composition, wherein
the plating layer of the laminated body is provided on at least two surfaces that are paired, and
the PAS resin composition is obtained by mixing the PAS resin (A), the thermoplastic resin (B) other than the PAS resin selected from the group consisting of the thermoplastic elastomer (b1) and the hydrolyzable thermoplastic resin (b2), the carbonate (C), and an olefin wax (D).

The PAS resin composition of the present disclosure contains as essential components the PAS resin (A), the thermoplastic resin (B), the carbonate (C), and the polyolefin wax (D), and if necessary, the optional component described above. A method for producing the PAS resin composition includes a step of mixing the PAS resin (A), the thermoplastic resin (B), the carbonate (C), and the polyolefin wax (D) as the essential components, and if necessary, the optional component, and melt-kneading them at a temperature equal to or higher than the melting point of the PAS resin.

In a preferable method for producing the PAS resin composition of the present disclosure, the PAS resin composition can be produced through a step of putting the essential components and the optional component in any form such as a powder, a pellet, or a strip, into a ribbon blender, a Henschel mixer, a V blender, or the like, dry blending the components, putting the components into a known melt-kneader such as a Banbury mixer, a mixing roll, a single- or twin-screw extruder, or a kneader, and melt-kneading the components such that the resin temperature is equal to or higher than the melting point of the PAS resin, preferably equal to or higher than the melting point by 10°C, more preferably within the range of the melting point plus 10°C to the melting point plus 100°C, and further preferably within the range of the melting point plus 20°C to the melting point plus 50°C. Each of the components may be added to the melt-kneader and mixed simultaneously or separately.

From the viewpoint of dispersibility and productivity, it is preferable that a melt-kneader be a twin-screw kneading extruder. For example, it is preferable that melt-kneading be performed while the amount of resin component discharged is controlled within the range of 5 to 500 (kg/hr) and the screw rotational speed is controlled within the range of 50 to 500 (rpm) as appropriate, and it is further preferable that melt-kneading be performed under a condition in which the ratio (the amount/the rotational speed) is within the range of 0.02 to 5 (kg/hr/rpm). When the filler and the additive among the components are added, it is preferable that the filler and the additive be supplied to the extruder from a side feeder of the twin-screw kneading extruder from the viewpoint of dispersibility. The side feeder is positioned such that the ratio of the distance between a resin-supplying portion (top feeder) of the extruder and the side feeder to the full length of screw of the twin-screw kneading extruder is preferably 0.1 or more, and more preferably 0.3 or more. The ratio is preferably 0.9 or less, and more preferably 0.7 or less.

The PAS resin composition thus obtained by melt-kneading is a melt-kneaded mixture containing the essential components, and the optional component and a component derived from the optional component added, if necessary. It is preferable that after the melt-kneading, a publicly known method be performed, for example, the PAS resin composition in a melted state be extrusion molded into a strand shape and then processed in a form of pellet, chip, granule, powder, or the like, and if necessary, pre-dried within the temperature range of 100 to 150°C, and subjected to various molding. During extrusion molding into a strand shape, the method may include a step of melting the resin composition according to the present invention at a shearing region where a shearing speed is preferably 500 sec⁻¹ or less, and more preferably 100 sec⁻¹ or less and 0 sec⁻¹ or more.

In addition to the PAS resin (A), the PAS resin composition of the present disclosure produced by the production method can contain the thermoplastic resin (B), the carbonate (C), and the polyolefin wax (D). The PAS resin composition is considered to have a morphology in which each dispersion phase of at least the thermoplastic resin (B) and the carbonate (C) is formed in a continuous phase of the PAS resin. Furthermore, it is considered that the use of the polyolefin wax (D) enhances an effect of extruding the thermoplastic resin (B) and the carbonate (C) onto a surface of the molded product, and as a result, a void formed by removing the thermoplastic resin (B) and the carbonate formed on the roughened surface of the PAS resin molded product in the roughening treatment step is easily filled with a metal, ceramic, or the like constituting the plating layer by the plating treatment, to further enhance the adhesive strength of the plating layer to the molded product.

A PAS resin molded product constituting the electromagnetic wave-shielding member of the present disclosure can be obtained, for example, by melt-molding the PAS resin composition. A method for manufacturing the PAS resin molded product of the present invention includes a step of melt-molding the PAS resin composition. The method for manufacturing the PAS resin molded product of the present invention may include a step of melting the PAS resin composition according to the present invention at a shearing region where a shearing speed is preferably 500 sec⁻¹ or less, and more preferably 100 sec⁻¹ or less and 0 sec⁻¹ or more. Melt-molding may be carried out by a known method. For example, various molding methods such as injection molding, compression molding, blow molding, and transfer molding are applicable. Under molding by injection molding, each molding condition is not particularly limited. The PAS resin composition can be molded usually by a general method. For example, after a step of melting the PAS resin composition in an injection molding machine such that the resin temperature is equal to or higher than the melting point of the PAS resin, preferably equal to or higher than the melting point by 10°C, more preferably within the range of the melting point plus 10°C to the melting point plus 100°C, and further preferably within the range of the melting point plus 20°C to the melting point plus 50°C, the PAS resin composition may be injected into a mold from a resin discharge port and molded. At that time, the temperature range of the mold is a known temperature range, for example, preferably room temperature (23°C) or higher, more preferably 40°C or higher, and further preferably 120°C or higher. The temperature of the mold is preferably 300°C or lower, more preferably 200°C or lower, and further preferably 180°C or lower.

The shape of the PAS resin molded product of the present disclosure is not particularly limited, and may be a plate, a box, a cylinder, a hemisphere, or the like. The shape of a bottom surface thereof may be a round, a polygon, or a combination thereof. The thickness of the PAS resin molded product is preferably 0.5 mm or more, more preferably 1.0 mm or more, and preferably 50 mm or less, and more preferably 10 mm or less. When the PAS resin molded product has a bottom and a wall, the thickness ratio (bottom/wall) is preferably within the range of 0.1 to 10 from the viewpoint of mechanical properties. A connection portion between the bottom and the wall may have a radius of curvature R. The PAS resin molded product may have a rib, a boss, a pin, a snap fit, or the like. In addition, another member may be combined on the surface of the PAS resin molded product.

The laminated body constituting the electromagnetic wave-shielding member of the present disclosure is manufactured by a manufacturing method including a step (hereinafter sometimes simply referred to as "roughening treatment step") of roughening the surface of the PAS resin molded product formed by molding the PAS resin composition through a chemical etching treatment, and a step (hereinafter sometimes simply referred to as "plating treatment step") of subjecting the roughened surface of the molded product to a plating treatment.

The laminated body constituting the electromagnetic wave-shielding member of the present disclosure has a plating layer on at least two surfaces that are paired, of the PAS resin molded product. Therefore, the laminated body can exhibit more excellent magnetic field shielding properties than a laminated plate having a plating layer on only a surface even when the total plating thickness is the same. Since the total plating thickness can be decreased, the amount of material used can be decreased, and a plating treatment time can be shortened.

The roughening treatment step includes a step of bringing the surface of the PAS resin molded product into contact with an etchant by applying through immersion.

The etchant is not particularly limited as long as it can remove the thermoplastic resin (B) and the carbonate (C) that are present on the surface of the PAS resin molded product. For example, an etchant containing a strong acid or a salt thereof is preferred. Examples of the strong acid or the salt thereof include chromic acid, sulfuric acid, ammonium fluoride, nitric acid, and chromic anhydride. One type or two or more types of the strong acid or the salt thereof may be used in combination. A condition where the surface of the PAS resin molded product is brought into contact with the etchant is preferably a condition where the concentration of the strong acid or the salt thereof in the etchant, and a temperature and a time during contact are appropriately controlled.

A known etchant can be used. For example, an etchant described in Japanese Unexamined Patent Application Publication No. H5-155127, that is, an etchant containing 400 g/L of sulfuric acid, 400 g/L of chromic anhydride, and a dilution water (an amount corresponding to a total amount of etchant of 1 L) can be used.

In the roughening treatment step, a void is formed by removing at least a portion of the thermoplastic resin (B) and the carbonate (C) that are uniformly dispersed on the surface of the PAS resin molded product. The presence of the void and an increase in specific surface area further enhance an interaction with metal particles constituting the plating layer, and the adhesive strength of the PAS resin molded product to the plating layer is increased. When a plating layer is conventionally tried to be bonded through a coating film formed from an adhesive or the like in a direction vertical to a surface of a molded product, the adhesive or the like that is uncured during production is dropped due to an influence of its own weight, and the film thickness is biased. Thus, the adhesive strength tends to be uneven. In the present invention, the void tends to be less likely to be made uneven depending on a position on the surface of the molded product, and the adhesive strength is excellent in uniformity. The surface roughness of the roughened surface of the PAS resin molded product is not particularly limited. From the viewpoint of excellent adhesive strength, the average roughness Rz of ten points is preferably 0.1 um or more, and more preferably 1 um or more, and preferably 10 um or less, and more preferably 5 um or less.

The plating treatment step includes a step of forming a plating layer formed from a metal and/or ceramic on the roughened surface of the PAS resin molded product through an electroless plating method, an electrolytic plating method, a sputtering method, or a combination thereof.

The electroless plating method is preferred since the void formed by removing the thermoplastic resin (B) and the carbonate formed on the roughened surface of the PAS resin molded product is easily filled with a metal or ceramic constituting the plating layer by the plating treatment and the adhesive strength of the plating layer is further enhanced.

In the electroless plating method, for example, the roughened surface of the PAS resin molded product is brought into contact with an electroless plating solution to precipitate a metal such as copper contained in the electroless plating solution. Thus, an electroless plating layer (coating film) formed from a metal coating film can be formed.

Examples of the electroless plating solution include an electroless plating solution containing at least one metal selected from the group consisting of nickel, copper, chromium, zinc, iron, gold, silver, aluminum, tin, cobalt, palladium, lead, platinum, cadmium, manganese, lithium, strontium, lanthanum, titanium, barium, zirconium, lead, and rhodium, a reductant, and a solvent such as an aqueous medium or an organic solvent.

Examples of the reductant include dimethylaminoborane, hypophosphorous acid, sodium hypophosphite, dimethylamine borane, hydrazine, formaldehyde, sodium borohydride, and phenol.

As the electroless plating solution, an electroless plating solution containing, if necessary, a complexing agent such as an organic acid including a monocarboxylic acid such as acetic acid or formic acid; a dicarboxylic acid compound such as malonic acid, succinic acid, adipic acid, maleic acid, or fumaric acid; a hydroxycarboxylic acid compound such as malic acid, lactic acid, glycolic acid, gluconic acid, or citric acid; an amino acid compound such as glycine, alanine, iminodiacetic acid, arginine, aspartic acid, or glutamic acid; or an aminopolycarboxylic acid compound such as iminodiacetic acid, nitrilotriacetic acid, ethylenediaminediacetic acid, ethylenediaminetetraacetic acid, or diethylenetriaminepentaacetic acid, or a soluble salt (sodium salt, potassium, ammonium salt, etc.) of the organic acid, or an amine compound such as ethylenediamine, diethylenetriamine, or triethylenetetramine can be used.

The electroless plating solution is preferably used at a temperature range of 20 to 98°C.

The electrolytic plating method is, for example, a method in which while an electrolytic plating solution is brought into contact with the surface of the electroless plating layer (coating film) formed by the electroless plating method, a current is applied to precipitate a metal such as copper contained in the electrolytic plating solution on the surface of the electroless plating layer (coating film) that is disposed on a cathode and is formed by the electroless plating method, forming an electrolytic plating layer (coating film).

Examples of the electrolytic plating solution include an electrolytic plating solution containing a sulfuric acid salt of at least one metal selected from the group consisting of nickel, copper, chromium, zinc, iron, gold, silver, aluminum, tin, cobalt, palladium, lead, platinum, cadmium, manganese, lithium, strontium, lanthanum, titanium, barium, zirconium, lead, and rhodium, an acid, and an aqueous medium. Specifically, an electrolytic plating solution containing iron (II) sulfate, nickel (II) sulfate, boric acid, and an aqueous medium is preferably used since a permalloy plating layer is obtained. When there is the permalloy plating layer, magnetic permeability is high, and favorable magnetic field shielding properties can be achieved.

The electrolytic plating solution is preferably used at a temperature range of 20 to 98°C.

The sputtering method is a method in which an inert gas (mainly argon) is introduced in vacuum, a positive voltage is applied to the PAS resin molded product, and a negative voltage is applied to a metal material or a ceramic material (target) forming a plating layer to generate glow discharge, as a result, the inert gas atoms are ionized, gas ions vigorously collide against a surface of the target at a high speed, an atom and a molecule constituting the target are ejected and attached to the roughened surface of the PAS resin molded product, to form the plating layer.

Examples of the sputtering method include a diode sputtering method, a magnetron sputtering method, a dual magnetron sputtering method, a reactive sputtering method, and an ion beam sputtering method. One type or two or more types of the sputtering methods may be used in combination. As an application mode of the target, any of direct current (DC) sputtering, DC pulse sputtering, alternating current (AC) sputtering, or radio-frequency (RF) sputtering can be used.

Examples of the target used in the sputtering method include a target containing at least one metal selected from the group consisting of nickel, copper, chromium, zinc, iron, gold, silver, aluminum, tin, cobalt, palladium, lead, platinum, cadmium, manganese, lithium, strontium, lanthanum, titanium, barium, zirconium, lead, and rhodium. In particular, permalloy, sendust, and ferrite are preferred. When the plating layer contains permalloy, sendust, and ferrite, magnetic permeability is high, and favorable magnetic field shielding properties can be achieved.

The thickness of the plating layer formed by the plating treatment is not particularly limited, and is preferably within the range of 0.1 um or more and 500 um or less. The thickness of the plating layer formed by the plating treatment can be adjusted by a treatment time, the number of treatment, a current density, the amount of used additive for plating, and the like in the plating treatment step.

The laminated body of the present disclosure manufactured by the manufacturing method described above can be used alone as the electromagnetic wave-shielding member, or a plurality of laminated bodies can be connected and used. A method for connection is not particularly limited. Examples thereof include a mechanical connection method using a screw, a rivet, a snap-fit, or the like, a method using an adhesive, and a connection method through welding.

The shape of the electromagnetic wave-shielding member of the present disclosure is not particularly limited as long as it is a shape that surrounds an article to be shielded from electromagnetic wave, and may be a box, a cylinder, a hemisphere, or the like. The shape of a bottom surface thereof may be a round, a polygon, or a combination thereof. The thickness of a bottom and a wall is preferably 0.5 mm or more, more preferably 1.0 mm or more, and preferably 50 mm or less, and more preferably 10 mm or less. From the viewpoint of mechanical properties, the thickness ratio (bottom/wall) of the bottom to the wall is preferably within the range of 0.1 to 10. A connection portion between the bottom and the wall may have a radius of curvature R. The bottom and the wall may have a rib, a boss, a pin, a snap fit, or the like. In addition, another member may be provided on a bottom surface and a wall surface.

The electromagnetic wave-shielding member of the present disclosure is bonded to the roughened surface of the PAS resin molded product, that is, the plating layer that is formed by the plating treatment in the void formed by removing the thermoplastic resin (B) and the carbonate (C) and is a thin film layer formed from a metal or ceramic is bonded to the PAS resin molded product through high adhesive strength.

The electromagnetic wave-shielding member of the present disclosure is excellent in electric field shielding properties and magnetic field shielding properties. Specifically, the electric field shielding properties measured at 1 GHz by a KEC method is 100 dB or more, and the magnetic field shielding properties measured at 100 kHz by the KEC method is 10 dB or more. The KEC method is a method developed by KEC Electronic Industry Development Center (KEC), and represents a method for measuring electromagnetic wave shield characteristics in KEC.

### Examples

Hereinafter, the present invention will be described in detail by using Examples, but the present invention is not limited to the following Examples. "%" and "part(s)" are based on mass unless other specified.

### (PAS Resin Composition and Step of Manufacturing PAS Resin Molded Product)

Materials other than glass fibers were uniformly mixed in a tumbler in accordance with composition components and the amounts (all in part(s) by mass) of components mixed of a resin composition shown in each of Table 1 and 2. The materials were put into a supply port (top feeder) of a twin-screw extruder with a vent ("TEX30α" manufactured by The Japan Steel Works, Ltd.), and glass fibers were further put into a side feeder, melt-kneaded at a resin component discharge amount of 30 kg/hr, a screw rotational speed of 220 rpm, and a set resin temperature of 320°C, and discharged from a discharge port into a strand shape. The discharged material was cut to obtain pellets.

Subsequently, the pellets were supplied to an injection molding apparatus ("SE75D-HP" manufactured by Sumitomo Heavy Industries, Ltd.) in which a cylinder temperature was set to 310°C, and injection molded using a plate molding mold in which a mold temperature was adjusted to 140°C, to obtain a PAS resin molded product (150 mm in length, 150 mm in width, and 3 mm in thickness) of each of Examples 1 to 6, Reference Examples 1 to 5, and Comparative Examples 1 to 3.

### [Example 1]

### (Step of Roughening PAS Resin Molded Product)

The PAS resin molded product obtained above was immersed in a chemical etching treatment liquid for 3 to 20 minutes, and drawn to form a roughened surface on the whole surface of the molded product. As the chemical etching treatment liquid, a chemical etching treatment liquid including 400 g/L of sulfuric acid, 400 g/L of chromic anhydride, and dilution water (an amount corresponding to a total amount of etchant of 1 L) was used.

### (Step 1 of Plating PAS Resin Molded Product)

Next, the whole roughened surface of the PAS resin molded product having the formed roughened surface was subjected to electroless copper plating by the following method. The PAS resin molded product was immersed in an electroless copper plating solution ("OIC copper" manufactured by OKUNO Chemical Industries Co., Ltd., pH: 12.5) at 55°C for 100 minutes, to form an electroless copper plating layer (thickness: 2.5 µm).

### (Step 2 of Plating PAS Resin Molded Product)

The surface of the electroless copper plating obtained above was sufficiently cleaned, the PAS resin molded product was immersed in an electroless nickel plating solution ("TOP NICORON SA-98" manufactured by OKUNO Chemical Industries Co., Ltd., pH: 9) at 30°C for 3 minutes, to form an electroless nickel plating layer (thickness: 0.25 µm).

### [Example 2]

The same operation as in Example 1 was carried out except that the thickness of the electroless copper plating was changed from 2.5 um to 1.0 um in Step 1 of Plating PAS Resin Molded Product.

### [Example 3]

The same operation as in Example 2 was carried out except that in Step 3 of Plating PAS Resin Molded Product was carried out instead of Step 2 of Plating PAS Resin Molded Product.

### (Step 3 of Plating PAS Resin Molded Product)

A cathode was disposed on a surface of the electroless copper plating obtained in Step 1 of Plating PAS Resin Molded Product, and nickel was disposed as an anode. Electronic plating was carried out with pulsed current at a current density of 63 A/dm², a pH of 2.7, and room temperature for 28 minutes using an electrolytic plating solution, to laminate a permalloy plating layer having a thickness of 5 um on the surface of the electroless copper plating film. In the pulsed current, a sum of a time when a current flowed (ON time) and a time when a current did not flow (OFF time) was set to one cycle, and the cycle time was stepwisely shortened from an ON time:an OFF time = 2,000 msec:1,000 msec to 2 msec:1 msec. As the electrolytic plating solution, an electrolytic plating solution including an aqueous solution of 67 g/L of nickel (II) sulfate hexahydrate, 133 g/L of nickel (II) chloride hexahydrate, 5 g/L of iron (II) sulfate heptahydrate, 83 g/L of boric acid, 83 g/L of sodium chloride, 5 g/L of saccharin sodium, and 0.3 g/L of sodium laurylsulfate was used.

### [Example 4]

The same operation as in Example 2 was carried out except that in Step 4 of Plating PAS Resin Molded Product was carried out instead of Step 2 of Plating PAS Resin Molded Product.

### (Step 4 of Plating PAS Resin Molded Product)

The PAS resin molded product and sendust as a sputtering target were disposed in a vacuum chamber (SSP1000 manufactured by Toyoko Kagaku Co., Ltd.). The air in the vacuum chamber was discharged, argon was introduced, and the argon gas atmosphere was kept at a sputtering gas pressure of 4×10⁻¹ Pa in the chamber. A sputter power of 1 kW was applied to the target to start sputtering. When the film thickness reached a desired film thickness, the application of electric voltage was released to terminate sputtering. Subsequently, the PAS resin molded product was flipped and disposed in the chamber. Another surface was subjected to sputtering similarly.

### [Example 5]

The same operation as in Example 4 was carried out except that as a target to be used, ferrite was used instead of sendust in Step 4 of Plating PAS Resin Molded Product.

### [Example 6]

The step of roughening the PAS resin molded product and the step of plating the PAS resin molded product were carried out in the same manner as in Example 1.

### [Reference Example 1]

To a surface having a length of 150 mm and a width of 150 mm of the PAS resin molded product, a masking tape for plating (masking tape 851A for plating manufactured by 3M Company) was attached so as to cover the whole surface. The same operation as in Example 1 was carried out except that the thickness of the electroless copper plating was changed to 5 um in Step 1 of Plating PAS Resin Molded Product and the thickness of the electroless nickel plating was changed to 0.5 um in Step 2 of Plating PAS Resin molded product. After the plating steps, the masking tape for plating was removed to obtain an electromagnetic wave-shielding member having a plating layer on only one surface among two paired surfaces.

### [Reference Example 2]

The same operation as in Reference Example 1 was carried out except that the thickness of the electroless copper plating was changed from 5 um to 2 um in Step 1 of Plating PAS Resin Molded Product.

### [Reference Example 3]

The same operation as in Reference Example 2 was carried out except that plating was carried out by a method in Step 3 of Plating PAS Resin Molded Product instead of Step 2 of Plating PAS Resin Molded Product and the thickness of an electrolytic permalloy plating layer was changed from 5 um to 10 µm.

### [Reference Example 4]

The same operation as in Reference Example 2 was carried out except that plating was carried out by a method in Step 4 of Plating PAS Resin Molded Product instead of Step 2 of Plating PAS Resin Molded Product and the thickness of a sendust plating layer was changed from 5 um to 10 µm.

### [Reference Example 5]

The same operation as in Reference Example 4 was carried out except that as a target to be used, ferrite was used instead of sendust in Step 4 of Plating PAS Resin Molded Product.

### [Comparative Example 1]

The same operation as in Example 1 was carried out. A plating layer was not formed, and the PAS resin molded product having no plating layer was obtained.

### [Comparative Example 2]

The step of roughening the PAS resin molded product and the step of plating the PAS resin molded product were carried out in the same manner as in Example 1.

### [Comparative Example 3]

The same operation as in Example 1 was carried out. A plating layer was not formed, and the PAS resin molded product having no plating layer was obtained.

By the method described above, a laminated body having a plating layer on the PAS resin molded product in each of Examples 1 to 6, Reference Examples 1 to 5, and Comparative Example 1 to 3 was obtained. The following evaluations were carried out for the obtained laminated bodies.

### <Evaluation>

### (1) Measurement of Plating Adherence (Adhesive Properties)

A cross cut test was carried out using an adhesive tape specified in JIS Z 1522 (adherence: about 8 N for a width of 25 mm, nominal width: 12 to 19 mm, Sellotape (registered trademark) No. 405 manufactured by Nichiban Co., Ltd.). Specifically, the following procedure was carried out. To a plating surface in which a streak having such a depth that reached a base metal was formed with a sharp tool so as to form a 3 by 6 grid composed of 18 squares each having a side length of 2 mm, a center of a tape was disposed on the squares and evenly attached with the finger such that a 30-to 50-mm tape edge not attached to the base metal was left. With care to prevent air bubbles from being formed at that time, the tape was continuously and strongly pushed at 20 N/cm² for about 10 seconds. Within 1 minute, the left tape edge not attached was held and peeled at an angler relative to the plating surface of 90° and a speed of 200 cm/sec. For a sample having a plating layer on two paired surfaces, the surfaces were evaluated, and a worse result was adopted. In Tables, "0/18" means that the number of squares peeled was zero, and "18/18" means that the number of squares peeled was 18. A smaller number of peeled surfaces of the 18 squares was evaluated to express higher adhesive strength. The evaluation results are shown in Tables 1 and 2.

### (2) Evaluation of Electric Field Shielding Properties and Magnetic Field Shielding Properties

The electric field shielding properties and magnetic field shielding properties of the laminated body produced in each of Examples 1 to 6, Reference Examples 1 to 5, and Comparative Examples 1 to 3 were measured by a KEC method. The evaluation results of the electric field shielding properties [dB] at a frequency of 1 GHz and the magnetic field shielding properties [dB] at a frequency of 100 kHz were shown in Tables 1 and 2.

**[Table 1]**

| | | Exampl e 1 | Exampl e 2 | Exampl e 3 | Exampl e 4 | Exampl e 5 | Exampl e 6 |
|---|---|---|---|---|---|---|---|
| Resin Compositi on | A | 100 | 100 | 100 | 100 | 100 | 100 |
| | b1-1 | 22.1 | 15.1 | 10.1 | 11.5 | 11.5 | 8.3 |
| | b1-2 | 9.5 | 6.5 | 4.3 | 4.9 | 4.9 | 3.6 |
| | b2-1 | | 13.4 | 21.7 | | 20.2 | |
| | b2-2 | | | | 20.2 | | |
| | C-1 | 78.9 | 67.5 | 43.4 | 68.3 | | 59.5 |
| | C-3 | | | | | 68.3 | |
| | D-1 | 0.5 | 0.5 | 0.5 | 0.5 | 0.5 | |
| | D-2 | | | | | | 0.5 |
| | E | 47.4 | 62.1 | 72.3 | 62.8 | 62.8 | 54.8 |
| Plating layer | Both surfaces/ one surface | Both surfac es | Both surfac es | Both surfac es | Both surfac es | Both surfac es | Both surfac es |
| | Chemical etching treatment | O | O | O | O | O | O |
| | Electrole ss plating | O | O | O | O | O | O |
| | Electroly tic plating | | | O | | | |
| | Sputterin 9 | | | | O | O | |
| | G-1 (thicknes s: µm) | 2.5 | 1.0 | 1.0 | 1.0 | 1.0 | 2.5 |
| | G-2 (thicknes s: µm) | 0.25 | 0.25 | | | | 0.25 |
| | G-3 (thicknes s: µm) | | | 5.0 | | | |
| | G-4 (thicknes s: µm) | | | | 5.0 | | |
| | G-5 (thicknes s: µm) | | | | | 5.0 | |
| Evaluatio n | Plating adherence | 0/18 | 0/18 | 0/18 | 0/18 | 4/18 | 1/18 |
| | Electric field | 117.6 | 115.4 | 119.6 | 117.2 | 118.2 | 118.0 |
| | shielding propertie s [dB] at 1 GHz | | | | | | |
| | Magnetic field shielding propertie s [dB] at 100 kHz | 13.2 | 11.0 | 17.0 | 23.0 | 15.9 | 12.0 |

**[Table 2]**

| | | Refe renc e Exam ple 1 | Refe renc e Exam ple 2 | Refe renc e Exam ple 3 | Refe renc e Exam ple 4 | Refe renc e Exam ple 5 | Compa rativ e Examp le 1 | Compa rativ e Examp le 2 | Compa rativ e Examp le 3 |
|---|---|---|---|---|---|---|---|---|---|
| Resin Compo sitio n | A | 100 | 100 | 100 | 100 | 100 | 100 | 100 | 100 |
| | b1-1 | 22.1 | 15.1 | 10.1 | 11.5 | 11.5 | 7.8 | 22.1 | |
| | b1-2 | 9.5 | 6.5 | 4.3 | 4.9 | 4.9 | 3.3 | 9.5 | |
| | b2-1 | | 13.4 | 21.7 | | 20.2 | | | |
| | b2-2 | | | | 20.2 | | | | |
| | C-1 | 78.9 | 67.5 | 43.4 | 68.3 | | | | |
| | C-2 | | | | | | 40 | 65.8 | |
| | C-3 | | | | | 68.3 | | | |
| | D-1 | 0.5 | 0.5 | 0.5 | 0.5 | 0.5 | | | 0.9 |
| | D-2 | | | | | | 0.5 | | |
| | d-3 | | | | | | | 0.5 | |
| | E | 47.4 | 62.1 | 72.3 | 62.8 | 62.8 | 66.7 | 60.5 | 75.1 |
| Plati ng layer | Both surfac es/one surfac | One surf ace | One surf ace | One surf ace | One surf ace | One surf ace | Not attac hed | Both surfa ces | Not attac hed |
| | e | | | | | | | | |
| | Chemic al etchin g treatm ent | O | O | O | O | O | O | O | O |
| | Electr oless plating | O | O | O | O | O | O | O | O |
| | Electr olytic plating | | | O | | | | | |
| | Sputte ring | | | | O | O | | | |
| | G-1 (thick ness: µm) | 5.0 | 2.0 | 2.0 | 2.0 | 2.0 | Not attac hed | 2.5 | Not attac hed |
| | G-2 (thick ness: | 0.5 | 0.5 | | | | | 0.25 | |
| | µm) | | | | | | | | |
| | G-3 (thick ness: µm) | | | 10.0 | | | | | |
| | G-4 (thick ness: µm) | | | | 10.0 | | | | |
| | G-5 (thick ness: µm) | | | | | 10.0 | | | |
| Evalu ation | Plating adhere nce | 0/18 | 0/18 | 0/18 | 0/18 | 5/18 | - | 17/18 | - |
| | Electr ic field shield ing proper ties | 116. 8 | 115. 9 | 117. 8 | 116. 5 | 117. 1 | 0.0 | 118.0 | 0.0 |
| | [dB] at 1 GHz | | | | | | | | |
| | Magnet ic field shield ing proper ties [dB] at 100 kHz | 3.2 | 1.2 | 4.0 | 8.1 | 7.7 | 0.0 | 11.9 | 0.0 |

### <Raw Materials Used>

Hereinafter, raw materials for a PAS resin composition and components constituting a plating layer are described.
- PAS Resin
   (A) Linear polyphenylene sulfide resin: Melt viscosity (V6): 8 Pa·s
- Thermoplastic elastomer other than PAS resin (thermoplastic elastomer)
   (b1-1) Olefin polymer "BONDFAST 7L" (ethylene-maleic anhydride-glycidyl methacrylate copolymer), manufactured by Sumitomo Chemical Co., Ltd.
   (b1-2) Olefin polymer "Engage 8842" (ethylene-[alpha]-olefin polymer), manufactured by The Dow Chemical Company
- Thermoplastic elastomer other than PAS resin (hydrolyzable thermoplastic resin)
   (b2-1) Polyamide resin "AMODEL A-1004", Amodel Specialty Polymers
   (b2-2) Polycarbonate resin "Iupilon MB4304R", manufactured by Mitsubishi Chemical Corporation
- Carbonate
   (C-1) Calcium carbonate "Calcium carbonate NS #2300" (average particle diameter*³: 1.0 pm), manufactured by Nitto Funka Kogyo K.K.
   (C-2) Calcium carbonate "Calcium carbonate grade 1" (average particle diameter*³: 6.4 µm), manufactured by SANKYO SEIFUN
   (C-3) Magnesium carbonate (synthetic magnesite) "MAGTHERMO MS-S" (average particle diameter*³: 1.2 pm), manufactured by Konoshima Chemical Co., Ltd.

The average particle diameter*³: the average particle diameter of a powder calculated from an expression (average particle diameter = 6/(specific gravity × specific surface area) × 10,000 [pm]) using the specific surface area per gram of the powder with a powder specific surface area measurement device "SS-100" manufactured by Shimadzu Corporation
- Wax
   (D-1) High-density polyethylene wax "Luwax AH-6" manufactured by BASF
   (D-2) Maleic anhydride polyethylene "Licolub CE-2" manufactured by Clariant (Japan) K.K.
   (d-3) Pentaerythritol fatty acid ester "LOXIOL VPG861" manufactured by Green Polymer Additives
- Other
   (E) Glass fiber "T-717H" (fiber length: 3 mm, average diameter: 10 µm) manufactured by Nippon Electric Glass Co., Ltd.
- Components constituting plating layer
   (G-1) Copper
   (G-2) Nickel
   (G-3) Permalloy (Fe-Ni alloy, Nickel content: 70 to 85%)
   (G-4) Sendust (Fe-Si-Al alloy, Si content: 9.5 to 10.5%, Al content: 4.5 to 5.5%)
   (G-5) Ferrite (Fe₂O₃-MnO-ZnO ceramic, MnO content: 33 to 40%, ZnO content: 6 to 130)

## Claims

1. A method for manufacturing an electromagnetic wave-shielding member that is a laminated body, the method comprising:
a step of roughening a surface of a molded product obtained by molding a polyarylene sulfide resin composition by a chemical etching treatment; and
a step of subjecting the roughened surface of the molded product to a plating treatment, wherein
the laminated body has a plating layer on at least two surfaces that are paired, and
the polyarylene sulfide resin composition is obtained by mixing a polyarylene sulfide resin (A), a thermoplastic resin (B) other than the polyarylene sulfide resin selected from the group consisting of a thermoplastic elastomer (b1) and a hydrolyzable thermoplastic resin (b2), a carbonate (C), and a polyolefin wax (D).

2. The method for manufacturing an electromagnetic wave-shielding member according to claim 1, wherein the step of roughening the surface of the molded product obtained by molding the polyarylene sulfide resin composition by the chemical etching treatment is a step of bringing an etchant containing a strong acid or a salt thereof into contact with the surface of the molded product.

3. The method for manufacturing an electromagnetic wave-shielding member according to claim 1 or 2, wherein the carbonate (C) is a granular substance having an average particle diameter of 0.3 um or more and 6 µm or less.

4. The method for manufacturing an electromagnetic wave-shielding member according to any one of claims 1 to 3, wherein the carbonate (C) is at least one selected from the group consisting of calcium carbonate, magnesium carbonate, potassium carbonate, sodium carbonate, sodium bicarbonate, ammonium carbonate, barium carbonate, lithium carbonate, copper (II) carbonate, iron (II) carbonate, silver (I) carbonate, magnesium carbonate, zinc carbonate, dolomite, and hydromagnesite.

5. The method for manufacturing an electromagnetic wave-shielding member according to any one of claims 1 to 4, wherein a fibrous filler is further contained.

6. The method for manufacturing an electromagnetic wave-shielding member according to any one of claims 1 to 5, wherein the plating treatment is an electroless plating method, an electrolytic plating method, a sputtering method, or a combination thereof.

7. The method for manufacturing an electromagnetic wave-shielding member according to any one of claims 1 to 6, wherein a component constituting the plating layer contains at least one metal from the group consisting of nickel, copper, chromium, zinc, iron, gold, silver, aluminum, tin, cobalt, palladium, lead, platinum, cadmium, manganese, lithium, strontium, lanthanum, titanium, barium, zirconium, lead, and rhodium.

8. The method for manufacturing an electromagnetic wave-shielding member according to any one of claims 1 to 6, wherein a component constituting the plating layer contains at least one from permalloy, sendust, and ferrite.

9. An electromagnetic wave-shielding member that is a laminated body obtained by laminating a plating layer on a roughened surface of a molded product obtained by molding a polyarylene sulfide resin composition, wherein
the plating layer of the laminated body is provided on at least two surfaces that are paired, and
the polyarylene sulfide resin composition is obtained by mixing a polyarylene sulfide resin (A), a thermoplastic resin (B) other than the polyarylene sulfide resin selected from the group consisting of a thermoplastic elastomer (b1) and a hydrolyzable thermoplastic resin (b2), a carbonate (C), and a polyolefin wax (D).

10. The electromagnetic wave-shielding member according to claim 9, wherein the carbonate (C) is a granular substance having an average particle diameter of 0.3 um or more and 6 µm or less.

11. The electromagnetic wave-shielding member according to claim 9 or 10, wherein the carbonate is at least one selected from the group consisting of calcium carbonate, magnesium carbonate, potassium carbonate, sodium carbonate, sodium bicarbonate, ammonium carbonate, barium carbonate, lithium carbonate, copper (II) carbonate, iron (II) carbonate, silver (I) carbonate, magnesium carbonate, zinc carbonate, dolomite, and hydromagnesite.

12. The electromagnetic wave-shielding member according to any one of claims 9 to 11, further comprising a fibrous filler.

13. The electromagnetic wave-shielding member according to any one of claims 9 to 12, wherein a component constituting the plating layer contains at least one metal from the group consisting of nickel, copper, chromium, zinc, iron, gold, silver, aluminum, tin, cobalt, palladium, lead, platinum, cadmium, and rhodium.
